# EUROPEAN PATENT SPECIFICATION

(11) **EP 4 391 016 B1**
(45) Date of publication and mention of the grant of the patent: **25.11.2026**
(21) Application number: 22866768.9
(22) Date of filing: 09.09.2022
(51) Int. Cl.: H10B 63/10, H10N 70/20

(54) **PHASE CHANGE MEMORY UNIT AND PHASE CHANGE MEMORY**
PHASENWECHSELSPEICHEREINHEIT UND PHASENWECHSELSPEICHER
UNITÉ DE MÉMOIRE À CHANGEMENT DE PHASE ET MÉMOIRE À CHANGEMENT DE PHASE

(30) Priority: 13.09.2021 CN 202111068031; 21.07.2022 CN 202210863735
(43) Date of publication of application: 26.06.2024
(73) Proprietor: Huawei Technologies Co., Ltd., Shenzhen, Guangdong 518129 (CN)
(72) Inventor: LI, Xiang, Shenzhen, Guangdong 518129 (CN); GUO, Yanrong, Shenzhen, Guangdong 518129 (CN); CHEN, Xin, Shenzhen, Guangdong 518129 (CN); MA, Ping, Shenzhen, Guangdong 518129 (CN); TONG, Hao, Shenzhen, Guangdong 518129 (CN)
(74) Representative: Thun, Clemens
(86) International application number: PCT/CN2022/118183
(87) International publication number: WO 2023/036307

(56) References cited:
- EP-A2- 1 879 232
- WO-A1-2021/083010
- CN-A- 107 665 947
- CN-A- 110 036 479
- CN-A- 110 335 942
- CN-A- 110 335 942
- CN-A- 111 320 145
- CN-A- 111 320 145
- US-A1- 2007 221 905
- US-A1- 2008 073 637
- US-A1- 2018 182 958
- US-A1- 2022 231 224
- US-A1- 2022 344 584
- WANG RUOBING ET AL: "High thermal stability and fast operation speed phase-change memory devices containing Hf-doped Ge2Sb2Te5 films", MATERIALS LETTERS, vol. 278, 26 July 2020 (2020-07-26), AMSTERDAM, NL, pages 128402, XP093217412, ISSN: 0167-577X, DOI: 10.1016/j.matlet.2020.128402

## Description

### TECHNICAL FIELD

This disclosure relates to the field of storage technologies, and in particular, to a phase change storage unit and a phase change memory.

### BACKGROUND

With the wide application of technologies such as mobile Internet, cloud computing, big data, deep learning, and Internet of Things, the market has a growing demand for ultra-high density and ultra-large capacity data storage. A phase change memory (phase change memory, PCM), as one of the most promising non-volatile storage technologies for application, has been used in a plurality of storage structure directions. For example, in a two-dimensional memory structure direction, a two-dimensional phase change memory has been used in an embedded application. For another example, in a three-dimensional memory structure direction, a three-dimensional phase change memory, as a storage class memory (storage class memory), has been used in a scenario such as a data center.

The phase change memory has advantages such as low power consumption, high density, and a small size, and implements data reading and writing through a conductivity difference shown when a phase change material changes between a crystalline state and an amorphous state in an electrical pulse manner. Currently, in the phase change memory, the phase change material is mainly a material of GeₓSb_{y}Te_{1-x-y}. Because a nucleation center of the material of GeₓSb_{y}Te_{1-x-y} in the amorphous state is unstable, a nucleation step in a crystallization process is slow, and a SET operation speed is slow. In addition, a density difference of the material of GeₓSb_{y}Te_{1-x-y} in the crystalline state and the amorphous state is large, a material volume changes repeatedly in a cyclic operation process, and it is easy to cause generation of a void. As a result, cycling performance is poor.

CN 111 320 145 A discloses tellurides doped with hafnium or indium as phase change materials.

'WANG RUOBING ET AL: "High thermal stability and fast operation speed phase-change memory devices containing Hf-doped Ge2Sb2Te5 films", MATERIALS LETTERS, vol. 278, 26 July 2020, page 128402' discloses tellurides doped with hafnium as phase change materials.

US 2022/0231224 A1 discloses a phase-changing chalcogenide layer with a neighbouring layer of good thermal stability and adhesion to dielectric materials in order to increase cycling performance.

US 2022/0344584 A1 discloses the utilisiation of two paired phase-changing materials with mutually compensating expansion/shrinkage in order to prevent stress formation during phase transformation of a multitude of layers.

EP 1 879 232 A2 discloses a phase change memory cell with different phase change materials.

US 2007/0221905 A1 discloses a phase change memory and methods for forming the same.
US 2018/0182958 A1 discloses a memory cell that includes a storage element and a selector element to minimize volume changes and electromigration. The storage element comprises a phase change material, such as a germanium-antimony-tellurium (GST) compound, which is doped with a dopant including hafnium. Furthermore, the selector element comprises a chalcogenide material. The storage element and the selector element are arranged as layers disposed between conductive electrodes.

### SUMMARY

This disclosure provides a phase change storage unit and a phase change memory, so as to improve a SET operation speed of the phase change memory and improve cycling performance of the phase change memory, wherein the invention is defined by the subject matter of the independent claim and preferred embodiments are subject matter of the dependent claims.

According to a first aspect, this disclosure provides a phase change storage unit, where the phase change storage unit includes a first electrode, a second electrode, and a phase change material layer. The phase change material layer is located between the first electrode and the second electrode, the phase change material layer includes a parent phase change material doped with a hafnium (Hf) metal and/or a hafnium compound, and the parent phase change material is a material including at least one of elements of germanium (Ge), antimony (Sb), tellurium (Te), and bismuth (Bi).
In the phase change storage unit provided in this disclosure, the phase change material layer includes the parent phase change material doped with the hafnium metal and/or the hafnium compound, and the hafnium metal and/or the hafnium compound may be used as a crystal nucleus in a crystallization process, to accelerate a crystallization process of the phase change material layer, thereby improving a SET operation speed. In addition, the doped hafnium metal and/or hafnium compound may fill a vacancy when the parent phase change material is in a crystalline state, to reduce a volume change of the phase change material layer before and after a phase change, thereby reducing generation of a void and improving cycling performance.

In a possible implementation of this disclosure, an atomic percentage of the hafnium metal and/or the hafnium compound in the phase change material layer is 0.1% to 40%. In this implementation, the atomic percentage of the hafnium metal and/or the hafnium compound in the phase change material layer is 0.1% to 40%, so that a crystallization speed of the phase change material layer can be increased, and the cycling performance can be improved.

The following provides several examples of the atomic percentage of the hafnium metal and/or the hafnium compound in the phase change material layer:
Example 1: The atomic percentage of the hafnium metal and/or the hafnium compound in the phase change material layer is 1.5% to 6.5%.
Example 2: The atomic percentage of the hafnium metal and/or the hafnium compound in the phase change material layer is 10% to 19.5%.
Example 3: The atomic percentage of the hafnium metal and/or the hafnium compound in the phase change material layer is 25% to 35%.

All the three examples can improve the crystallization speed of the phase change material layer and improve the cycling performance. The crystallization speed is sequentially Example 3, Example 2, and Example 1 in ascending order, and a quantity of cycles is sequentially Example 1, Example 2, and Example 3 in ascending order. Generally, a higher crystallization speed indicates better performance of the phase change material layer, and a higher quantity of cycles indicates better performance of the phase change material layer. Therefore, the performance of the phase change material layer in the three examples has respective advantages and disadvantages.

In a possible implementation of this disclosure, the parent phase change material includes any one of the following materials: GeₓSb_{y}Te_{1-x-y} and GeₓBi_{y}Te_{1-x-y}, where a value range of a sum of x and y is 0 to 100%.

In a possible implementation of this disclosure, the hafnium compound includes at least one of the following: a hafnium metal oxide, a hafnium metal boride, a hafnium metal carbide, a hafnium metal nitrogen compound, a hafnium metal chalcogenide, a hafnium metal halogen compound, and a binary or multi-ary compound formed by a hafnium metal and another metal.

In a possible implementation of this application, the phase change storage unit may further include a gating material layer, and the gating material layer is located between the first electrode and the second electrode. A specific disposition location of the gating material layer is not limited in this application. The gating material layer may be in a high resistance state at a low voltage, so as to suppress a leakage current, and may be in a low resistance state at a high voltage, so as to provide a sufficient current for read and write operations.

In a possible implementation of this disclosure, the phase change storage unit may further include at least one of the following layers located between the first electrode and the second electrode: an insulation layer, a heating layer, an adhesion layer, and a buffer layer.

When the insulation layer is specifically disposed, the insulation layer may wrap an exposed surface of the phase change material layer, and the insulation layer is non-conductive. In this case, a current passes through the phase change material layer in a centralized manner, so that current density and current heating efficiency can be improved. A specific disposition location of the insulation layer is not limited in this disclosure.

When the heating layer is specifically disposed, the heating layer may be disposed between any two layers between the first electrode and the second electrode. For example, the heating layer is disposed between the first electrode and the phase change material layer. For another example, the heating layer is disposed between the phase change material layer and the second electrode. A specific disposition location of the heating layer is not limited in this application. The heating layer can improve a resistance of the entire unit, thereby improving the heating efficiency of the unit current.

When the adhesion layer is specifically disposed, the adhesion layer may be disposed between any two layers between the first electrode and the second electrode. A specific disposition location of the adhesion layer is not limited in this application. The adhesion layer can improve an adhesion effect between two layers adjacent to the adhesion layer.

When the buffer layer is specifically disposed, the buffer layer may be disposed between any two layers between the first electrode and the second electrode. A specific disposition location of the buffer layer is not limited in this application. The buffer layer can reduce mutual diffusion of two adjacent material layers in the phase change storage unit in repeated erase and write (or reset/set) operations, thereby improving reliability.

In a possible implementation of this disclosure, the phase change material layer is prepared by using a chemical vapor deposition method, physical vapor deposition, or atomic layer deposition.

According to a second aspect, this disclosure provides another phase change storage unit, where the phase change storage unit includes a first electrode, a second electrode, and a phase change material layer. The phase change material layer is located between the first electrode and the second electrode, the phase change material layer includes at least one hafnium-containing material layer and at least one chalcogenide layer that are laminated, the hafnium-containing material layer includes at least one of the following materials: a hafnium (Hf) metal, a hafnium compound, a parent phase change material doped with the hafnium metal and/or the hafnium compound, and the parent phase change material is a material including at least one of elements of germanium (Ge), antimony (Sb), tellurium (Te), and bismuth (Bi).

In the phase change storage unit provided in this disclosure, the phase change material layer includes the at least one hafnium-containing material layer and the at least one chalcogenide layer that are laminated, and the doped hafnium metal and/or hafnium compound included in the hafnium-containing material layer may be used as a crystal nucleus in a crystallization process, to accelerate a crystallization process, thereby improving a SET operation speed. In addition, the phase change material layer includes at least two layers of laminated structures, so that thermal conductivity of the phase change storage unit is changed, and an interface between the two material layers hinders heat conduction. Therefore, heating efficiency can be improved, and power consumption of a RESET operation can be reduced, thereby reducing a probability of generating a void, and improving cycling performance. In addition, the chalcogenide layer further helps to suppress a low-resistance failure caused by conduction between upper and lower electrodes caused by element segregation in the hafnium-containing material layer, thereby improving the cycling performance of the phase change storage unit, and helping reduce a resistance drift.

In a possible implementation of this disclosure, the chalcogenide layer includes at least one of the following materials: a tellurium compound of a tellurium (Te) element and at least one of elements of germanium (Ge), antimony (Sb), titanium (Ti), tantalum (Ta), scandium (Sc), bismuth (Bi), silicon (Si), carbon (C), platinum (Pt), and indium (In) and a tellurium compound doped with a hafnium metal and/or a hafnium compound.

In a possible implementation of this disclosure, the parent phase change material includes any one of the following materials: GeₓSb_{y}Te_{1-x-y}, GeₓBi_{y}Te_{1-x-y}, and SbₓTe_{y}, where a value range of a sum of x and y is 0 to 100%.

In a possible implementation of this disclosure and according to the present invention, the hafnium-containing material layer and the chalcogenide layer that are included in the phase change material layer are alternately arranged. In this manner, if an element segregation problem occurs in a hafnium-containing material layer, and the hafnium-containing material layer is conducted, a simple substance precipitated from the hafnium-containing material layer may be combined with a material in a chalcogenide layer adjacent to the hafnium-containing material layer, so that the low-resistance failure caused by conduction of the entire phase change material layer can be effectively suppressed, thereby improving the cycling performance of the phase change storage unit, and reducing the resistance drift.

In a possible implementation of this disclosure, the phase change material layer includes at least three material layers that are laminated, the at least three material layers include at least one hafnium-containing material layer and at least one chalcogenide layer, and the hafnium-containing material layer and the chalcogenide layer that are included in the at least three material layers are alternately arranged. In this manner, a quantity of interfaces in the phase change material layer can be increased, and the thermal conductivity can be further reduced. Therefore, the heating efficiency can be improved, and the power consumption of the RESET operation can be reduced, thereby reducing the probability of generating a void and further improving the cycling performance.

In a possible implementation of this disclosure, the phase change storage unit further includes a gating material layer located between the first electrode and the second electrode. A specific disposition location of the gating material layer is not limited in this disclosure. The gating material layer may be in a high resistance state at a low voltage, so as to suppress a leakage current, and may be in a low resistance state at a high voltage, so as to provide a sufficient current for read and write operations.

In a possible implementation of this disclosure, the phase change storage unit may further include at least one of the following layers located between the first electrode and the second electrode: an insulation layer, an electrode layer, a heating layer, an adhesion layer, and a buffer layer.

When the insulation layer is specifically disposed, the insulation layer may wrap an exposed surface of the phase change material layer, and the insulation layer is non-conductive. In this case, a current passes through the phase change material layer in a centralized manner, so that current density and current heating efficiency can be improved. A specific disposition location of the insulation layer is not limited in this disclosure.

When the electrode layer is specifically disposed, the electrode layer may be disposed between any two layers between the first electrode and the second electrode. A specific disposition location of the electrode layer is not limited in this disclosure.

When the heating layer is specifically disposed, the heating layer may be disposed between any two layers between the first electrode and the second electrode. For example, the heating layer is disposed between the first electrode and the phase change material layer. For another example, the heating layer is disposed between the phase change material layer and the second electrode. A specific disposition location of the heating layer is not limited in this disclosure. The heating layer can improve a resistance of the entire unit, thereby improving the heating efficiency of the unit current.

When the adhesion layer is specifically disposed, the adhesion layer may be disposed between any two layers between the first electrode and the second electrode. A specific disposition location of the adhesion layer is not limited in this disclosure. The adhesion layer can improve an adhesion effect between two layers adjacent to the adhesion layer.

When the buffer layer is specifically disposed, the buffer layer may be disposed between any two layers between the first electrode and the second electrode. A specific disposition location of the buffer layer is not limited in this disclosure. The buffer layer can reduce mutual diffusion of two adjacent material layers in the phase change storage unit in repeated erase and write (or reset/set) operations, thereby improving reliability.

In a possible implementation of this disclosure, the phase change material layer is prepared by using a chemical vapor deposition method, a physical vapor deposition method, or an atomic layer deposition method.

According to a third aspect, this disclosure provides a phase change memory, including a controller and a storage medium, where the storage medium includes an array including the phase change storage unit in the first aspect and the possible implementations of the first aspect, or an array including the phase change storage unit in the second aspect and the possible implementations of the second aspect.

### BRIEF DESCRIPTION OF DRAWINGS

FIG. 1A is a schematic diagram of a structure of a phase change storage unit according to an embodiment of this disclosure;
FIG. 1B is another schematic diagram of a structure of a phase change storage unit according to an embodiment of this disclosure;
FIG. 2 is a schematic diagram of a vertical cross section of a phase change material layer 13 including one material layer according to an embodiment of this disclosure;
FIG. 3 is a schematic diagram of a vertical cross section of a phase change material layer 13 including two material layers according to an embodiment of this disclosure;
FIG. 4 is another schematic diagram of a vertical section of a phase change material layer 13 including two material layers according to an embodiment of this disclosure;
FIG. 5 is another schematic diagram of a vertical section of a phase change material layer 13 including two material layers according to an embodiment of this disclosure;
FIG. 6 is another schematic diagram of a vertical section of a phase change material layer 13 including two material layers according to an embodiment of this disclosure;
FIG. 7 is a schematic diagram of a vertical cross section of a phase change material layer 13 including at least three material layers according to an embodiment of the present invention;
FIG. 8 is another schematic diagram of a vertical cross section of a phase change material layer 13 including at least three material layers according to an embodiment of the present invention;
FIG. 9 is another schematic diagram of a vertical cross section of a phase change material layer 13 including at least three material layers according to an embodiment of the present invention;
FIG. 10 is another schematic diagram of a vertical cross section of a phase change material layer 13 including at least three material layers according to an embodiment of the present invention;
FIG. 11 is another schematic diagram of a structure of a phase change storage unit according to an embodiment of this disclosure;
FIG. 12 is another schematic diagram of a structure of a phase change storage unit according to an embodiment of this disclosure;
FIG. 13 is another schematic diagram of a structure of a phase change storage unit according to an embodiment of this disclosure;
FIG. 14 is a schematic diagram of a structure of a phase change memory according to an embodiment of the present invention;
FIG. 15 is another schematic diagram of a structure of a phase change memory according to an embodiment of the present invention; and
FIG. 16 is a schematic diagram of value ranges of x and y in GeₓSb_{y}Te_{1-x-y} according to an embodiment of the present invention.

### Icon description:

1-phase change storage unit;
11-first electrode;
12-second electrode;
13-phase change material layer;
131-hafnium-containing material layer;
132- chalcogenide layer;
14-gating material layer;
15-insulation layer;
16-heating layer;
17-first electrode layer;
18-second electrode layer;
19-third electrode layer;
2-first electrode line; and
3-second electrode line.

### DESCRIPTION OF EMBODIMENTS

Terms used in the following embodiments are merely intended to describe specific embodiments, and are not intended to limit this disclosure. As used in the specification and the appended claims of this disclosure, the singular expressions "a/an", "one", "said", "the above", "the" and "this" are intended to also include such expressions as "one or more", unless otherwise clearly indicated in the context.

Reference to "an embodiment", "some embodiments", or the like described in the specification of this disclosure indicates that one or more embodiments of this disclosure include a specific feature, structure, or characteristic described with reference to embodiments. Therefore, statements "in an embodiment", "in some embodiments", "in some other embodiments", "in other embodiments", and the like that appear at different places in this specification do not necessarily refer to a same embodiment. Instead, the statements mean "one or more but not all of embodiments", unless otherwise specifically emphasized in another manner. The terms "include", "comprise", "have", and variations thereof all mean "including, but not limited to", unless otherwise particularly specified.

To facilitate understanding of a phase change storage unit and a phase change memory that are provided in embodiments of this disclosure, the following describes application scenarios of the phase change storage unit and the phase change memory. The phase change memory provided in this disclosure may be configured to store data in an electronic device such as a mobile phone, a tablet computer, a notebook computer, a wearable device, or an in-vehicle device. The phase change memory is a non-volatile memory based on a chalcogenide phase change material, and can be converted in different resistance states in a heat action. Data 0 and data 1 are stored by using a difference of 10 to 10000 times a resistance value between a high resistance state (a reset state) and a low resistance state (a set state) of the phase change memory. A set operation is an operation from the high resistance state to the low resistance state, and a reset operation is an operation from the low resistance state to the high resistance state.

Currently, in the phase change memory, a phase change material is mainly a material of GeₓSb_{y}Te_{1-x-y}. Because a nucleation center of the material of GeₓSb_{y}Te_{1-x-y} in an amorphous state is unstable, a nucleation step in a crystallization process is slow, and a SET operation speed is slow. In addition, a density difference of the material of GeₓSb_{y}Te_{1-x-y} in a crystalline state and the amorphous state is large, a material volume changes repeatedly in a cyclic operation process, and it is easy to cause generation of a void. As a result, cycling performance is poor. To resolve the foregoing problem, this disclosure provides a phase change storage unit and a phase change memory. The following describes the phase change storage unit and the phase change memory in the technical solutions of this disclosure with reference to the accompanying drawings.

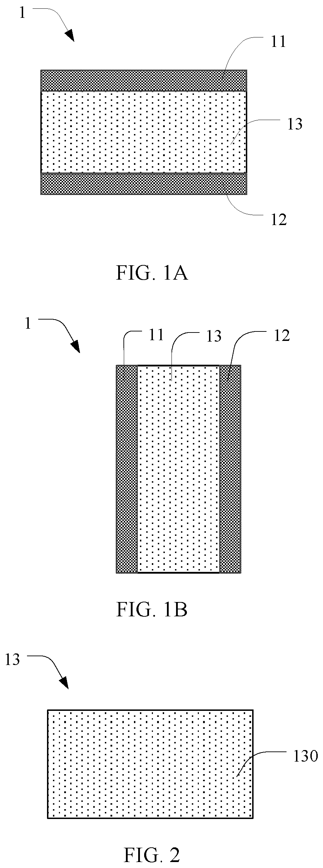

FIG. 1A is a schematic diagram of a structure of a phase change storage unit according to an embodiment of this disclosure, As shown in FIG. 1A, a phase change storage unit 1 in this embodiment of this disclosure includes a first electrode 11, a second electrode 12, and a phase change material layer 13. The phase change material layer 13 is located between the first electrode 11 and the second electrode 12.

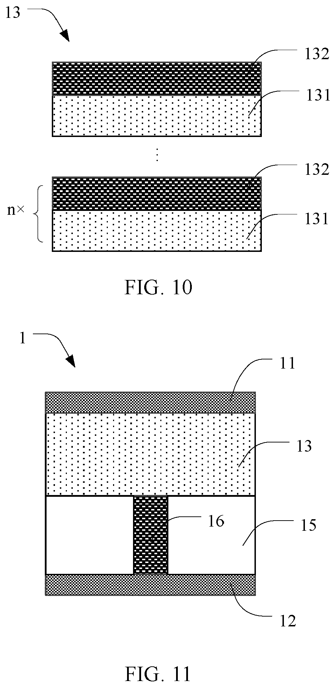

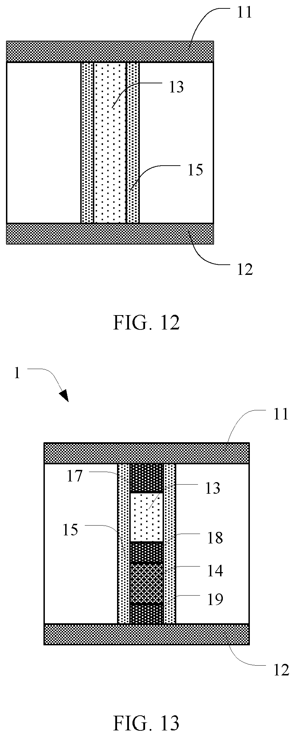

It should be noted that the first electrode 11 and the second electrode 12 in this embodiment of this disclosure may be in an up-down structure shown in FIG. 1A. In other words, the first electrode 11 is above the second electrode 12 in a vertical direction. It should be understood that in some other embodiments, the first electrode 11 may alternatively be below the second electrode 12 in the vertical direction. This is not limited in this embodiment of this disclosure. In some other embodiments, the first electrode 11 and the second electrode 12 may be in a left-right structure shown in FIG. 1B. In other words, the first electrode 11 is on the left of the second electrode 12 in a horizontal direction. It should be understood that in some other embodiments, the first electrode 11 may alternatively be on the right of the second electrode 12 in the horizontal direction. This is not limited in this embodiment of this disclosure. Similarly, the first electrode 11 and the second electrode 12 in FIG. 11, FIG. 13, and FIG. 13 below may be the up-down structure in the vertical direction or the left-right structure in the vertical direction. Details are not described in the following.

For ease of description, in the following embodiments, the first electrode 11 and the second electrode 12 are schematically described by using the up-down structure in the vertical direction. Details are not described in the following.

The phase change material layer 13 has a first resistance state and a second resistance state, and a resistance value of the phase change material layer 13 in the first resistance state is different from a resistance value of the phase change material layer 13 in the second resistance state, so that read and write operations may be performed by controlling and reading a current resistance value of the phase change storage unit 1. It should be understood that the phase change material layer 13 may have more than two resistance states, and may have a plurality of resistance states. A quantity of resistance states of the phase change material layer 13 is not limited in this disclosure.

In this embodiment of this disclosure, the phase change material layer 13 may have a plurality of possible implementations, which are separately described below.

In a possible implementation 1, the phase change material layer 13 includes one material layer.

FIG. 2 is a schematic diagram of a vertical cross section of a phase change material layer 13 including one material layer according to an embodiment of this disclosure. As shown in FIG. 2, the phase change material layer 13 includes one material layer 130, where the material layer 130 includes a parent phase change material 130 doped with a hafnium (Hf) metal and/or a hafnium compound, and the parent phase change material is a material including at least one of elements of germanium (Ge), antimony (Sb), tellurium (Te), and bismuth (Bi). A local crystalline structure of the hafnium metal and/or the hafnium compound is consistent with a local crystalline structure of a matrix material. In the implementation 1, the phase change material layer 13 includes the parent phase change material doped with the hafnium metal and/or the hafnium compound, and the hafnium metal and/or the hafnium compound may be used as a crystal nucleus in a crystallization process, to accelerate a crystallization process of the phase change material layer 13, thereby improving a SET operation speed. In addition, the doped hafnium metal and/or hafnium compound may fill a vacancy when the parent phase change material is in a crystalline state, to reduce a volume change of the phase change material layer 13 before and after a phase change, thereby reducing generation of a void and improving cycling performance.

In an embodiment of the present invention, atomic percentages of different parts of the hafnium-containing or the hafnium-containing compound in the phase change material are inconsistent. For example, when the phase change material is located between a top electrode and a bottom electrode, the atomic percentages of the hafnium-containing or the hafnium-containing compound in the phase change material are in a gradient change from high to low or from low to high in a direction from the top electrode to the bottom electrode.

In this embodiment of the present invention, an atomic percentage of the hafnium metal and/or the hafnium compound in the phase change material layer 13 is 0.1% to 40%. The atomic percentage of the hafnium metal and/or the hafnium compound is set in this way, so that a crystallization speed of the phase change material layer can be improved, and the cycling performance can be improved.

The following provides several examples of the atomic percentage of the hafnium metal and/or the hafnium compound in the phase change material layer:

Example 1: The atomic percentage of the hafnium metal and/or the hafnium compound in the phase change material layer 13 is 1.5% to 6.5%.

Example 2: The atomic percentage of the hafnium metal and/or the hafnium compound in the phase change material layer 13 is 10% to 19.5%.

Example 3: The atomic percentage of the hafnium metal and/or the hafnium compound in the phase change material layer 13 is 25% to 35%.

Example 4: The atomic percentage of the hafnium metal and/or the hafnium compound in the phase change material layer 13 is 7% to 14%.

Example 5: The atomic percentage of the hafnium metal and/or the hafnium compound in the phase change material layer 13 is 17% to 24%.

Example 6: The atomic percentage of the hafnium metal and/or the hafnium compound in the phase change material layer 13 is 27% to 34%.

All the six examples can improve the crystallization speed of the phase change material layer 13 and improve the cycling performance. The crystallization speed is sequentially Example 3, Example 2, and Example 1 in ascending order, and a quantity of cycles is sequentially Example 1, Example 2, and Example 3 in ascending order. Generally, a higher crystallization speed indicates better performance of the phase change material layer, and a higher quantity of cycles indicates better performance of the phase change material layer. Therefore, the performance of the phase change material layer in the three examples has respective advantages and disadvantages.

In an embodiment of according to the present invention, a specific material of the parent phase change material is not limited, and the parent phase change material may include any one of the following materials: GeₓSb_{y}Te_{1-x-y}, GeₓBi_{y}Te_{1-x-y}, SbₓTe_{y}, BiₓTe_{y}, GeₓTe_{y}, and Sb, where a value range of a sum of x and y is 0 to 100%. The parent phase change material may further include GeₓSb_{y}Bi_{z}Te_{1-x-y-z}, where a value range of a sum of x, y, and z is 0 to 100%.

For example, the parent phase change material is, for example, any one of GeₓSb_{y}Te_{1-x-y} and GeₓBi_{y}Te_{1-x-y}, where a value range of a sum of x and y is 0 to 100%.

For another example, the parent material may be SbₓTe_{y}, or the parent material further includes GeₓSb_{y}Bi_{z}Te_{1-x-y-z}, where a sum of x, y, and z is 100%.

In the materials GeₓSb_{y}Te_{1-x-y} and GeₓBi_{y}Te_{1-x-y}, x:y:(1-x-y)=4:1:5, 2:2:5, 3:2:6, 1:2:4, or 1:4:7, and in the material SbₓTe_{y}, x:y=2:3, 1:1, 2:1, or 1:0.

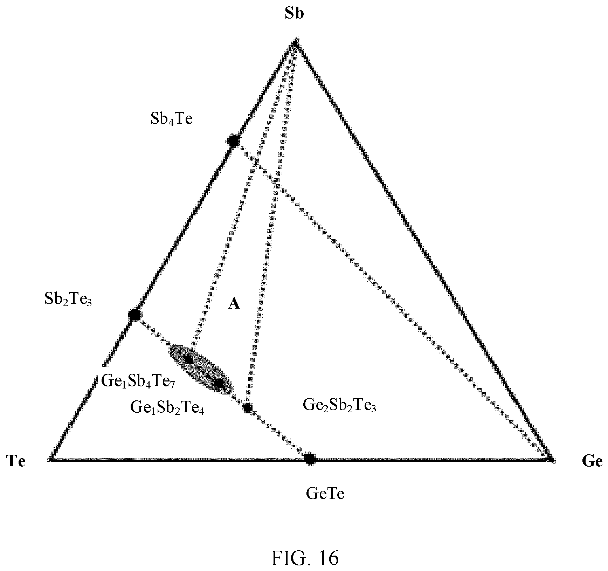

In another example, a value range of a concentration of GeₓSb_{y}Te_{1-x-y} may be a gray elliptic region and a quadrilateral region A shown in FIG. 16. The material GeₓSb_{y}Te_{1-x-y} in the region has a high-speed crystallization characteristic, and also has specific thermal stability. In the black elliptic region, 1/7-1/10≤x:(1-x-y)≤1/4+1/10 or 2/3-1/10≤y:(1-x-y)≤2/3+1/10, and in the quadrilateral region A, 1/7≤x:(1-x-y)≤2/5 and 2/3≤y:(1-x-y)≤4. In an embodiment of this disclosure, a specific material of the hafnium compound is not limited. The hafnium compound may include at least one of the following: a hafnium metal oxide (for example, HfO₂), a hafnium metal boride (for example, HfB), a hafnium metal carbide (for example, HfC), a hafnium metal nitride compound (for example, HfN), a hafnium metal chalcogenide (for example, HfS, HfSe, and HfTe), a hafnium metal halogen compound (for example, HfF, HfCl, and HfBr), and a binary or multi-ary compound (for example, HfTa, HfW, HfTi, and HfSc) formed by a hafnium metal and another metal.

In an embodiment of this disclosure, the phase change material layer 13 may be prepared by using a deposition method. For example, the deposition method may be a chemical vapor deposition (chemical vapor deposition, CVD) method, a physical vapor deposition (physical vapor deposition, PVD) method, or an atomic layer deposition (atomic layer deposition, ALD) method.

For example, in the physical vapor deposition method, two or more targets may be used. One target is an Hf-containing material, and the other target is a parent phase change material, or may be an alloy target. The alloy target includes both the Hf-containing material and the parent material. In a deposition process, N₂, O₂, and the like may be further added to form a nitride or oxide.

In a possible implementation 2, the phase change material layer 13 includes a plurality of material layers.

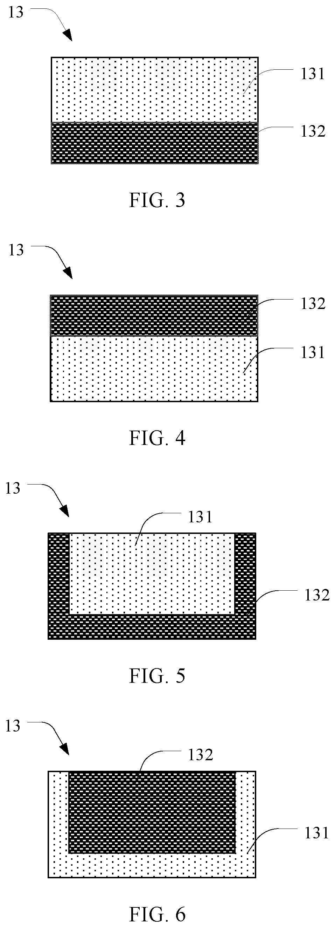

FIG. 3 to FIG. 10 are schematic diagrams of vertical cross sections of a phase change material layer 13 including a plurality of material layers according to an embodiment of this disclosure,

As shown in FIG. 3 to FIG. 10, the phase change material layer 13 includes at least one hafnium-containing material layer 131 and at least one chalcogenide layer 132 that are laminated. The hafnium-containing material layer 131 includes at least one of the following materials: a hafnium (Hf) metal, a hafnium compound, a parent phase change material doped with the hafnium metal and/or the hafnium compound, and the parent phase change material is a material of at least one of elements of germanium (Ge), antimony (Sb), tellurium (Te), and bismuth (Bi). In the implementation 2, the phase change material layer 13 includes the at least one hafnium-containing material layer 131 and the at least one chalcogenide layer 132 that are laminated, and the doped hafnium metal and/or hafnium compound included in the hafnium-containing material layer 131 may be used as a crystal nucleus in a crystallization process, to accelerate a crystallization process, thereby improving a SET operation speed. In addition, the phase change material layer 13 includes at least two layers of laminated structures, so that thermal conductivity of the phase change storage unit is changed, and an interface between the two material layers hinders heat conduction. Therefore, heating efficiency can be improved, and power consumption of a RESET operation can be reduced, thereby reducing a probability of generating a void, and improving cycling performance. In addition, the chalcogenide layer 132 further helps to suppress a low-resistance failure caused by conduction between upper and lower electrodes caused by element segregation in the hafnium-containing material layer 131, thereby improving the cycling performance of the phase change storage unit, and helping reduce a resistance drift.

In an embodiment of the present invention, the chalcogenide layer 132 may include at least one of the following materials: a tellurium compound of a tellurium (Te) element and at least one of elements of germanium (Ge), antimony (Sb), titanium (Ti), tantalum (Ta), scandium (Sc), bismuth (Bi), silicon (Si), carbon (C), platinum (Pt), and indium (In), and a tellurium compound doped with a hafnium metal and/or a hafnium compound.

For example, the chalcogenide layer 132 may be GeₓTe₁₋ₓ, SbₓTe₁₋ₓ, GeₓTe₁₋ₓ, TiₓTe₁₋ₓ, TaₓTe₁₋ₓ, ScₓTe₁₋ₓ, BiₓTe₁₋ₓ, GeₓSb₁₋ₓ, InₓTe₁₋ₓ, SiₓTe₁₋ₓ, CₓTe₁₋ₓ, PtₓTe₁₋ₓ, GeₓSb_{y}Te_{1-x-y}, GeₓBi_{y}Te_{1-x-y}, TaₓSb_{y}Te_{1-x-y}, TiₓSb_{y}Te_{1-x-y}, or ScₓSb_{y}Te_{1-x-y}, or may be an Hf-containing chalcogenide, for example, HfₓTe₁₋ₓ, HfₓSb_{y}Te_{1-x-y}, or HfGeₓSb_{y}Te_{1-x-y}, or an Hf-containing material in which a concentration of a hafnium atom is different from a concentration of a hafnium atom in the parent phase change material doped with the hafnium (Hf) metal and/or the hafnium compound in the implementation 1 (which may also be understood as an atomic percentage occupied by the hafnium atom in the parent phase change material doped with the hafnium (Hf) metal and/or the hafnium compound). A value range of a sum of x and y is 0 to 100%.

In an embodiment of the present invention, a specific material of the parent phase change material is not limited, and the parent phase change material may include any one of the following materials: GeₓSb_{y}Te_{1-x-y}, GeₓBi_{y}Te_{1-x-y}, SbₓTe_{y}, BiₓTe₁, GeₓTe_{y}, and Sb, where a value range of a sum of x and y is 0 to 100%. The parent phase change material may further include GeₓSb_{y}Bi_{z}Te_{1-x-y-z}, where a value range of a sum of x, y, and z is 0 to 100%.

For example, the parent phase change material is, for example, any one of GeₓSb_{y}Te_{1-x-y} and GeₓBi_{y}Te_{1-x-y}.

In an embodiment of the present invention, a specific material of the hafnium compound is not limited. The hafnium compound may include at least one of the following: a hafnium metal oxide (for example, HfO₂), a hafnium metal boride (for example, HfB), a hafnium metal carbide (for example, HfC), a hafnium metal nitride compound (for example, HfN), a hafnium metal chalcogenide (for example, HfS, HfSe, and HfTe), a hafnium metal halogen compound (for example, HfF, HfCl, and HfBr), and a binary or multi-ary compound (for example, HfTa, HfW, HfTi, and HfSc) formed by a hafnium metal and another metal.

In an example, a material combination of the hafnium-containing material layer 131 and the chalcogenide layer 132 may be, for example, any one of the following: HfGeₓSb_{y}Te_{1-x-y}/SbₓTe₁₋ₓ, HfGeₓSb_{y}Te_{1-x-y}/GeₓSb_{y}Te_{1-x-y}, HfGeₓSb_{y}Te_{1-x-y}/GeₓTe₁₋ₓ, HfGeₓSb_{y}Te_{1-x-y} (a concentration A)/HfGeₓSb_{y}Te_{1-x-y} (a concentration B), where the concentration A is different from the concentration B, HfO₂/ HfGeₓSb_{y}Te_{1-x-y}, and HfₓTe₁₋ₓ/HfGeₓSb_{y}Te_{1-x-y}, and the like.

In an embodiment of this disclosure, the hafnium-containing material layer 131 and the chalcogenide layer 132 that are included in the phase change material layer 13 are alternately arranged. In this manner, if an element segregation problem occurs in a hafnium-containing material layer 131, and the hafnium-containing material layer 131 is conducted, a simple substance precipitated from the hafnium-containing material layer 131 may be combined with a material in a chalcogenide layer 132 adjacent to the hafnium-containing material layer 131, so that the low-resistance failure caused by conduction of the entire phase change material layer 13 can be effectively suppressed, thereby improving the cycling performance of the phase change storage unit, and reducing the resistance drift.

Still refer to FIG. 3 to FIG. 6. The phase change material layer 13 includes a hafnium-containing material layer 131 and a chalcogenide layer 132. As shown in FIG. 3, the chalcogenide layer 132 may be located below the hafnium-containing material layer 131. It may be understood that, in the phase change storage unit, the chalcogenide layer 132 is located on a side that is of the hafnium-containing material layer 131 and that is away from the first electrode 11. As shown in FIG. 4, the chalcogenide layer 132 may alternatively be located above the hafnium-containing material layer 131. It may be understood that in the phase change storage unit, the chalcogenide layer 132 is located on a side that is of the hafnium-containing material layer 131 and that is away from the second electrode 12. As shown in FIG. 5, the chalcogenide layer 132 may alternatively be located below the hafnium-containing material layer 131, and the chalcogenide layer 132 wraps a side wall and a bottom of the hafnium-containing material layer 131. As shown in FIG. 6, the chalcogenide layer 132 may alternatively be located above the hafnium-containing material layer 131, and the hafnium-containing material layer 131 wraps a side wall and a bottom of the chalcogenide layer 132.

In an embodiment of this disclosure, the phase change material layer 13 includes at least three material layers that are laminated, the at least three material layers include at least one hafnium-containing material layer 131 and at least one chalcogenide layer 132, and the hafnium-containing material layer 131 and the chalcogenide layer 132 that are included in the at least three material layers are alternately arranged. In this manner, a quantity of interfaces in the phase change material layer 13 can be increased, and the thermal conductivity can be further reduced. Therefore, the heating efficiency can be improved, and the power consumption of the RESET operation can be reduced, thereby reducing the probability of generating a void and further improving the cycling performance.

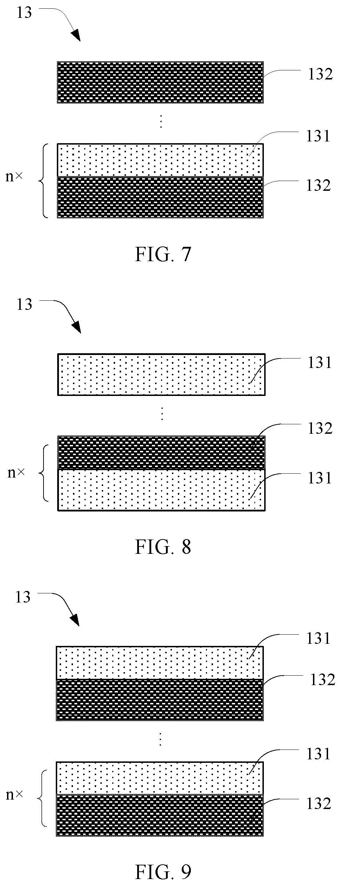

Still refer to FIG. 7 to FIG. 10, which are embodiments according to the present invention. The phase change material layer 13 includes three or more material layers, and a dual-layer material layer including the hafnium-containing material layer 131 and the chalcogenide layer 132, as a basic unit, is repeated n times, where n is an integer greater than 1. As shown in FIG. 7, both an uppermost layer and a lowermost layer of the phase change material layer 13 are the chalcogenide layers 132. As shown in FIG. 8, both an uppermost layer and a lowermost layer of the phase change material layer 13 are the hafnium-containing material layers 131. As shown in FIG. 9, an uppermost layer of the phase change material layer 13 is the hafnium-containing material layer 131, and a lowermost layer of the phase change material layer 13 is the chalcogenide layer 132. As shown in FIG. 10, an uppermost layer of the phase change material layer 13 is the chalcogenide layer 132, and a lowermost layer of the phase change material layer 13 is the hafnium-containing material layer 131.

In an embodiment of this disclosure, the at least one hafnium-containing material layer 131 and the at least one chalcogenide layer 132 included in the phase change material layer 13 may be prepared by using a deposition method. For example, the deposition method may be a chemical vapor deposition method, a physical vapor deposition method, or an atomic layer deposition method.

Based on the implementation 1 and the implementation 2, in an embodiment of this disclosure, the phase change storage unit may further include at least one of the following layers located between the first electrode 11 and the second electrode 12: an insulation layer, a heating layer, an adhesion layer, a buffer layer, and an electrode layer.

When the insulation layer is specifically disposed, the insulation layer may wrap an exposed surface of the phase change material layer 13, and the insulation layer is non-conductive. In this case, a current passes through the phase change material layer 13 in a centralized manner, so that current density and current heating efficiency can be improved. A specific disposition location of the insulation layer is not limited in this disclosure. A material of the insulation layer may be, for example, at least one of silicon dioxide (SiO₂), silicon nitride (SiN), or titanium nitride (TiN), or may be another material that can isolate a current. A specific material of the insulation layer is not limited in this disclosure,

When the heating layer is specifically disposed, the heating layer may be disposed between any two layers between the first electrode 11 and the second electrode 12. For example, the heating layer is disposed between the first electrode 11 and the phase change material layer 13. For another example, the heating layer is disposed between the phase change material layer 13 and the second electrode 12. A specific disposition location of the heating layer is not limited in this disclosure, The heating layer can improve a resistance of the entire unit, thereby improving the heating efficiency of the unit current.

When the adhesion layer is specifically disposed, the adhesion layer may be disposed between any two layers between the first electrode 11 and the second electrode 12. A specific disposition location of the adhesion layer is not limited in this disclosure. The adhesion layer can improve an adhesion effect between two layers adjacent to the adhesion layer.

When the buffer layer is specifically disposed, the buffer layer may be disposed between any two layers between the first electrode 11 and the second electrode 12. A specific disposition location of the buffer layer is not limited in this disclosure, The buffer layer can reduce mutual diffusion of two adjacent material layers in the phase change storage unit in repeated erase and write (or reset/set) operations, thereby improving reliability.

When the electrode layer is specifically disposed, the electrode layer may be disposed between any two layers between the first electrode 11 and the second electrode 12. A specific disposition location of the electrode layer is not limited in this disclosure.

For example, materials of the heating layer, the adhesion layer, and the buffer layer may be, for example, oxide, a boron compound, a carbon compound, a nitrogen compound, a chalcogenide, and a halogen compound. The specific materials of the heating layer, the adhesion layer, and the buffer layer are not limited in this disclosure, provided that corresponding functions of the material layers can be implemented.

Based on any one of the foregoing embodiments, the phase change storage unit may further include a gating material layer, and the gating material layer is located between the first electrode 11 and the second electrode 12. A specific disposition location of the gating material layer is not limited in this disclosure. The gating material layer may be in a high resistance state at a low voltage, so as to suppress a leakage current, and may be in a low resistance state at a high voltage, so as to provide a sufficient current for read and write operations.

The gating material layer may include a single material layer, or may include a plurality of material layers. In an example, the gating material layer includes the single material layer. During specific implementation, the gating material layer may include a matrix material doped with a hafnium metal and/or a hafnium compound. The matrix material may be, for example, GeₓAs_{y}Se(Te)_{1-x-y}, where a sum of x and y is equal to 1. For the hafnium compound, refer to the related descriptions of the hafnium compound in the phase change material layer 13. Details are not described herein again. In another example, the gating material layer may include the plurality of material layers. During specific implementation, the gating material layer may include at least one hafnium-containing material layer and at least one chalcogenide layer. For a specific implementation in which the gating material layer may include the plurality of material layers, refer to the related descriptions of the phase change material layer including the plurality of material layers. Details are not described herein again.

FIG. 11 is another schematic diagram of a structure of a phase change storage unit according to an embodiment of this disclosure, A phase change storage unit 1 shown in FIG. 11 is a T-type phase change storage unit. As shown in FIG. 11, the phase change storage unit 1 includes a first electrode 11, a second electrode 12, and a phase change material layer 13 located between the first electrode 11 and the second electrode 12. The phase change storage unit 1 may further include a heating layer 16 located between the phase change material layer 13 and the second electrode 12, and an insulation layer 15 further wraps a side wall of the heating layer 16. The heating layer 16 needs to meet a conductive requirement, and further needs to improve a resistance effect of the entire phase change storage unit. The phase change material layer 13 is located on the heating layer 16 with a small cross section size and the insulation layer 15 that wraps the side wall of the heating layer 16. The phase change material layer 13 is connected to the second electrode 12 below the phase change material layer 13 by the conductive heating layer, and is also connected to the first electrode 11 above the phase change material layer 13. The first electrode 11 and the second electrode 12 extend in different horizontal directions to connect different phase change storage units in a storage array.

FIG. 12 is another schematic diagram of a structure of a phase change storage unit according to an embodiment of this disclosure. A phase change storage unit 1 shown in FIG. 12 is a restrictive phase change storage unit. As shown in FIG. 12, the phase change storage unit 1 includes a first electrode 11, a second electrode 12, and a phase change material layer 13 located between the first electrode 11 and the second electrode 12. The phase change material layer 13 has a small cross section size, and is directly connected to the first electrode 11 above the phase change material layer 13 and the second electrode 12 below the phase change material layer 13. The phase change storage unit 1 may further include an insulation layer 15 located between the phase change material layer 13 and the second electrode 12, and the insulation layer 15 wraps a side wall of the phase change material layer 13.

FIG. 13 is another schematic diagram of a structure of a phase change storage unit according to an embodiment of this disclosure. A phase change storage unit 1 shown in FIG. 13 is a three-dimensional phase change storage unit. As shown in FIG. 13, the phase change storage unit 1 includes a first electrode 11, a second electrode 12, and a phase change material layer 13 located between the first electrode 11 and the second electrode 12. The phase change material layer 13 may further include a gating material layer 14 located between the first electrode 11 and the second electrode 12. Cross section sizes of the phase change material layer 13 and the gating material layer 14 are small. A first electrode layer 17, the phase change material layer 13, a second electrode layer 18, the gating material layer 14, and a third electrode layer 19 are sequentially included between the first electrode 11 and the second electrode 12. The phase change material layer 13 may be connected to the first electrode 11 by the first electrode layer 17, and the gating material layer 14 may be connected to the phase change material layer 13 by the second electrode layer 18, and is connected to the second electrode 12 by the second electrode layer 18. The phase change storage unit 1 may further include an insulation layer 15 located between the phase change material layer 13 and the second electrode 12. The insulation layer 15 wraps the phase change material layer 13, the gating material layer 14, and side walls of the electrode layers. The first electrode 11 and the second electrode 12 extend in different horizontal directions, to connect different phase change storage units in a storage array to form an array arranged on one layer. Such arrays are further stacked in a vertical direction to form a cross-stacked three-dimensional phase change memory.

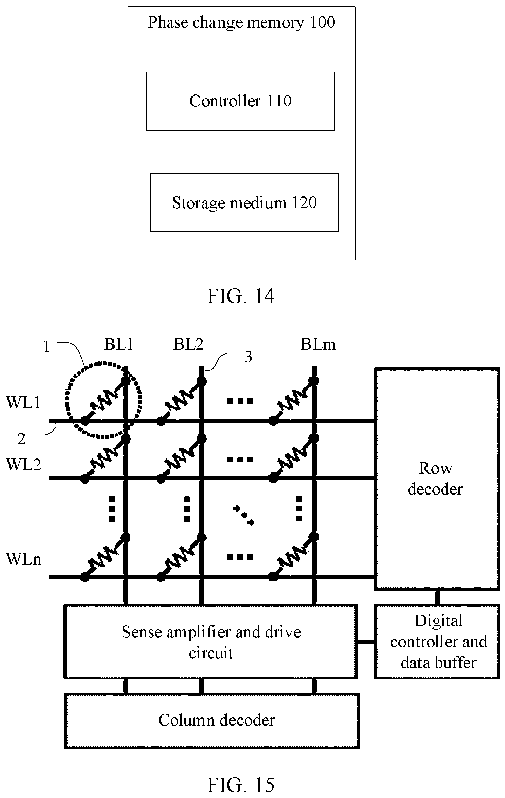

The present invention further provides a phase change memory. FIG. 14 is a schematic diagram of a structure of a phase change memory according to an embodiment of the present invention. As shown in FIG. 14, a phase change memory 100 includes a controller 110 and a storage medium 120. The storage medium 120 includes an array including the phase change storage unit 1 in any one of the foregoing embodiments.

The present invention further provides a phase change memory.

FIG. 15 is another schematic diagram of a structure of a phase change memory according to an embodiment of the present invention. As shown in FIG. 15, the phase change memory may further include a row decoder (row decoder), a column decoder (column decoder), a sense amplifier (sense amplifier), a drive circuit (drive circuit), a data buffer (data buffer), and a digital controller (digital controller). First electrodes 12 of a plurality of phase change storage units 1 are connected to form a first electrode line 2, second electrodes 13 of the plurality of phase change storage units 1 are connected to form a second electrode line 3, and an extending direction of the first electrode line 2 intersects with an extending direction of the second electrode line 3. Specifically, there is a uniquely determined phase change storage unit 1 at an intersection of the first electrode line 2 and the second electrode line 3. The row decoder of the phase change memory is electrically connected to all first electrode lines 2, and the column decoder, the sense amplifier, and the drive circuit are electrically connected to all second electrode lines 3. The row decoder, the column decoder, the sense amplifier, and the drive circuit are electrically connected to the digital controller and the data buffer respectively. One of the first electrode line 2 and the second electrode line 3 is a word line (word line, WL), and the other of the first electrode line 2 and the second electrode line 3 is a bit line (bit line, BL), so that one word line is connected to phase change storage units 1 in one row, and a level value different from that of another word line is applied to a selected word line, so as to select phase change storage units 1 in a row to perform read and write operations and the like. One bit line is connected to phase change storage units 1 in one column, and transmits an electrical signal of a write operation of the phase change storage unit 1 to a column selected by the column decoder, or transmits, along a selected column, an electrical signal obtained by an operation of a reading unit to the column decoder. Specifically, the first electrode line 2 may be used as the word line, and the second electrode line 3 may be used as the bit line; or the first electrode line 2 may be used as the bit line, and the second electrode line 3 may be used as the word line.

The following describes a working process of the phase change memory in the technical solutions of this disclosure by using an example in which the first electrode line 2 is the word line and the second electrode line 3 is the bit line. The row decoder of the phase change memory is electrically connected to all the first electrode lines 2, and the column decoder, the sense amplifier, and the drive circuit are electrically connected to all the second electrode lines 3. The row decoder, the column decoder, the sense amplifier, and the drive circuit are electrically connected to the digital controller and the data buffer respectively. Because there is a uniquely determined phase change storage unit 1 located at an intersection of the first electrode line 2 and the second electrode line 3, and the phase change storage unit 1 has different resistance states, read and write operations of a three-dimensional phase change memory can be implemented. When a read operation is performed, the digital controller controls the row decoder to modulate a voltage of the first electrode line 2 connected to a set phase change storage unit 1 to a read mode (for example, a voltage is 0V), and controls the column decoder to modulate a voltage of the second electrode line 3 connected to the set phase change storage unit 1 to the read mode (for example, a voltage is 1V). Then, a current of the set phase change storage unit 1 is measured by using the sense amplifier connected to the second electrode line 3, to determine a resistance state of a phase change material layer 13 of the phase change storage unit 1, so as to obtain a data storage state. When a write operation is performed, the digital controller controls the row decoder to modulate the voltage of the first electrode line 2 connected to the set phase change storage unit 1 to a write mode (for example, a voltage is 2V), and controls the column decoder to modulate the voltage of the second electrode line 3 connected to the set phase change storage unit 1 to the write mode (for example, a voltage is 0V), and then a write pulse current or pulse voltage is sent to the set phase change storage unit 1 by using the drive circuit connected to the second electrode line 3, to change a resistance state of the phase change storage unit 1, to implement the write operation. In addition, data read from the sense amplifier and data written to the phase change memory are stored in the data buffer.

In a specific embodiment, refer to FIG. 15. The phase change memory may be a two-dimensional phase change memory. In a specific embodiment, the phase change storage units 1 in the two-dimensional phase change memory may be arranged in an array, for example, may be arranged in n rows and m columns, where m and n are respectively positive integers greater than 1.

The present invention is defined in the appended claims.

## Claims

1. A phase change material (13) comprising a hafnium-containing material (131), the hafnium-containing material (131) is formed by doping hafnium metal or a hafnium-containing compound to a parent material, and the parent material comprises a compound that is formed by tellurium and at least one of germanium, antimony, and bismuth and that can perform a phase change, wherein:
• the phase change material (13) further comprises a chalcogenide (132), and the chalcogenide (132) is located above or below the hafnium-containing material (131); and
• the phase change material (13) comprises a plurality of basic units that are superposed together, and each basic unit comprises one layer of the Ahafnium-containing material (131) and one layer of the chalcogenide (132).

2. The phase change material according to claim 1, wherein atomic percentages of different parts of the hafnium metal or the hafnium-containing compound in the phase change material are inconsistent.

3. The phase change material according to claim 2, wherein when the phase change material is located between a top electrode and a bottom electrode, the atomic percentages of the hafnium metal or the hafnium-containing compound in the phase change material are in a gradient change from high to low or from low to high in a direction from the top electrode to the bottom electrode.

4. The phase change material according to any one of claims 1 to 3, wherein in the hafnium-containing material, an atomic percentage of the hafnium and/or the hafnium compound is 0.1% to 40%.

5. The phase change material according to any one of claims 2 to 4, wherein in the hafnium-containing material, the atomic percentage of the hafnium and/or the hafnium compound is 1.5% to 6.5%, 10% to 19.5%, 25% to 35%, 7% to 14%, 17% to 24%, or 27% to 34%.

6. The phase change material according to any one of claims 1 to 5, wherein the parent material comprises any one of the following materials: GeₓSb_{y}Te_{1-x-y} and GeₓBi_{y}Te_{1-x-y}, wherein a value range of a sum of x and y is greater than 0 and less than 100%, or the parent material further comprises SbₓTe_{y}, or the parent material further comprises GeₓSb_{y}Bi_{z}Te_{1-x-y-z}, wherein a sum of x, y, and z is 100%.

7. The phase change material according to claim 6, wherein in the materials GeₓSb_{y}Te_{1-x-y} and GeₓBi_{y}Te_{1-x-y}, x:y:(1-x-y)=4:1:5, 2:2:5, 3:2:6, 1:2:4, or 1:4:7, and in the material SbₓTe_{y}, x:y=2:3, 1:1, 2:1, or 1:0.

8. The phase change material according to any one of claims 1 to 7, wherein the hafnium compound comprises at least one of the following: a hafnium metal oxide, a hafnium metal boride, a hafnium metal carbide, a hafnium metal nitrogen compound, a hafnium metal chalcogenide, a hafnium metal halogen compound, and a binary or multi-ary compound formed by a hafnium metal and another metal.

9. A storage chip, wherein the storage chip (120) comprises a plurality of storage units, and each storage unit (1) comprises the phase change material according to any one of claims 1 to 7.

10. The storage chip according to claim 9, wherein each storage unit further comprises a gating material, and the gating material is doped with hafnium or a hafnium compound.

11. A phase change memory (100), comprising a controller (110) and at least one storage chip according to claim 9 or 10, wherein the controller is configured to store data to the at least one storage chip, or read data from the at least one storage chip.

12. An electronic device, wherein the electronic device comprises a processor and the phase change memory according to claim 11 and the processor is configured to store data to the phase change memory, or read data from the phase change memory.

## Patentansprüche

1. Phasenwechselmaterial (13), das ein Hafnium enthaltendes Material (131) umfasst, wobei das Hafnium enthaltende Material (131) durch Dotieren von Hafniummetall oder einer Hafnium enthaltenden Verbindung mit einem Grundmaterial gebildet wird und das Grundmaterial eine Verbindung umfasst, die durch Tellur und mindestens eines von Germanium, Antimon und Bismut gebildet wird und die einen Phasenwechsel durchführen kann, wobei:
• das Phasenwechselmaterial (13) ferner ein Chalkogenid (132) umfasst und sich das Chalkogenid (132) oberhalb oder unterhalb des Hafnium enthaltenden Materials (131) befindet; und
• das Phasenwechselmaterial (13) mehrere einander überlagerte Grundeinheiten umfasst und jede Grundeinheit eine Schicht des Hafnium enthaltenden Materials (131) und eine Schicht des Chalkogenids (132) umfasst.

2. Phasenwechselmaterial nach Anspruch 1, wobei Atomprozentsätze verschiedener Teile des Hafniummetalls oder der Hafnium enthaltenden Verbindung in dem Phasenwechselmaterial uneinheitlich sind.

3. Phasenwechselmaterial nach Anspruch 2, wobei, wenn sich das Phasenwechselmaterial zwischen einer oberen Elektrode und einer unteren Elektrode befindet, die Atomprozentsätze des Hafniummetalls oder der Hafnium enthaltenden Verbindung in dem Phasenwechselmaterial in einer Richtung von der oberen Elektrode zu der unteren Elektrode eine Gradientenänderung von hoch zu niedrig oder von niedrig zu hoch aufweisen.

4. Phasenwechselmaterial nach einem der Ansprüche 1 bis 3, wobei in dem Hafnium enthaltenden Material ein Atomprozentsatz des Hafniums und/oder der Hafniumverbindung 0,1 % bis 40 % beträgt.

5. Phasenwechselmaterial nach einem der Ansprüche 2 bis 4, wobei in dem Hafnium enthaltenden Material der Atomprozentsatz des Hafniums und/oder der Hafniumverbindung 1,5 % bis 6,5 %, 10 % bis 19,5 %, 25 % bis 35 %, 7 % bis 14 %, 17 % bis 24 % oder 27 % bis 34 % beträgt .

6. Phasenwechselmaterial nach einem der Ansprüche 1 bis 5, wobei das Grundmaterial eines der folgenden Materialien umfasst: GeₓSb_{y}Te_{1-x-y} und GeₓBi_{y}Te_{1-x-y}, wobei ein Wertebereich einer Summe von x und y größer als 0 und kleiner als 100 % ist oder das Grundmaterial ferner SbₓTe_{y} umfasst oder das Grundmaterial ferner GeₓSb_{y}Bi_{z}Te_{1-x-y-z} umfasst, wobei eine Summe von x, y und z 100 % beträgt.

7. Phasenwechselmaterial nach Anspruch 6, wobei in den Materialien GeₓSb_{y}Te_{1-x-y} und GeₓBi_{y}Te_{1-x-y} x:y:(1-x-y) = 4:1:5, 2:2:5,3:2:6,1:2:4 oder 1:4:7 ist und in dem Material SbₓTe_{y} x:y=2:3,1:1, 2:1 oder 1:0 ist.

8. Phasenwechselmaterial nach einem der Ansprüche 1 bis 7, wobei die Hafniumverbindung mindestens eines der Folgenden umfasst: ein Hafniummetalloxid, ein Hafniummetallborid, ein Hafniummetallcarbid, eine Hafniummetallstickstoffverbindung, ein Hafniummetallchalkogenid, eine Hafniummetallhalogenverbindung und eine binäre oder multi-äre Verbindung, die durch ein Hafniummetall und ein anderes Metall gebildet wird.

9. Speicherchip, wobei der Speicherchip (120) mehrere Speichereinheiten umfasst und jede Speichereinheit (1) das Phasenwechselmaterial nach einem der Ansprüche 1 bis 7 umfasst.

10. Speicherchip nach Anspruch 9, wobei jede Speichereinheit ferner ein Gating-Material umfasst und das Gating-Material mit Hafnium oder einer Hafniumverbindung dotiert ist.

11. Phasenwechselspeicher (100), der eine Steuerung (110) und mindestens einen Speicherchip nach Anspruch 9 oder 10 umfasst, wobei die Steuerung dazu ausgelegt ist, Daten in dem mindestens einen Speicherchip zu speichern oder Daten aus dem mindestens einen Speicherchip zu lesen.

12. Elektronische Vorrichtung, wobei die elektronische Vorrichtung einen Prozessor und den Phasenwechselspeicher nach Anspruch 11 umfasst und der Prozessor dazu ausgelegt ist, Daten in dem Phasenwechselspeicher zu speichern oder Daten aus dem Phasenwechselspeicher zu lesen.

## Revendications

1. Matériau à changement de phase (13) comprenant un matériau contenant de l'hafnium (131), le matériau contenant de l'hafnium (131) étant formé par dopage d'un métal hafnium ou d'un composé contenant de l'hafnium en un matériau parent, et le matériau parent comprenant un composé qui est formé par du tellure et au moins un élément parmi le germanium, l'antimoine et le bismuth et qui peut effectuer un changement de phase,
• le matériau à changement de phase (13) comprenant en outre un chalcogénure (132), et le chalcogénure (132) étant situé au-dessus ou au-dessous du matériau contenant de l'hafnium (131) ; et
• le matériau à changement de phase (13) comprenant une pluralité d'unités de base superposées les unes aux autres, et chaque unité de base comprenant une couche de matériau contenant de l'hafnium (131) et une couche de chalcogénure (132).

2. Matériau à changement de phase selon la revendication 1, les pourcentages atomiques de différentes parties du métal hafnium ou du composé contenant de l'hafnium dans le matériau à changement de phase étant incohérents.

3. Matériau à changement de phase selon la revendication 2, lorsque le matériau à changement de phase est situé entre une électrode supérieure et une électrode inférieure, les pourcentages atomiques du métal hafnium ou du composé contenant de l'hafnium dans le matériau à changement de phase étant dans un changement de gradient de haut en bas ou de bas en haut dans une direction de l'électrode supérieure à l'électrode inférieure.

4. Matériau à changement de phase selon l'une quelconque des revendications 1 à 3, dans le matériau contenant de l'hafnium, un pourcentage atomique du hafnium et/ou du composé de hafnium étant de 0,1 % à 40 %.

5. Matériau à changement de phase selon l'une quelconque des revendications 2 à 4, dans le matériau contenant de l'hafnium, le pourcentage atomique du hafnium et/ou du composé de hafnium étant de 1,5 % à 6.5 %, 10 % à 19.5 %, 25 % à 35 %, 7 % à 14 %, 17 % à 24 %, ou 27 % à 34 %.

6. Matériau à changement de phase selon l'une quelconque des revendications 1 à 5, le matériau parent comprenant l'une quelconque des matériaux suivants : GeₓSb_{y}Te_{1-x-y} et GeₓBi_{y}Te_{1-x-y}, une plage de valeurs d'une somme de x et y étant supérieure à 0 et inférieure à 100 %, ou le matériau parent comprenant en outre SbₓTe_{y}, ou le matériau parent comprenant en outre GeₓSb_{y}Bi_{z}Te_{1-x-y-z}, une somme de x, y et z étant de 100 %.

7. Matériau à changement de phase selon la revendication 6, dans les matériaux GeₓSb_{y}Te_{1-x-y} et GeₓBi_{y}Te_{1-x-y}, x:y:(1-x-y)=4:1:5, 2:2:5,3:2:6,1:2:4, ou 1:4:7, et dans le matériau SbₓTe_{y}, x:y=2:3,1:1, 2:1, ou 1:0.

8. Matériau à changement de phase selon l'une quelconque des revendications 1 à 7, le composé d'hafnium comprenant au moins l'un des suivants : un oxyde métallique d'hafnium, un borure métallique d'hafnium, un carbure métallique d'hafnium, un composé azoté métallique d'hafnium, un chalcogénure métallique d'hafnium, un composé halogéné métallique d'hafnium, et un composé binaire ou multi-aire formé par un métal d'hafnium et un autre métal.

9. Puce de stockage, la puce de stockage (120) comprenant une pluralité d'unités de stockage, et chaque unité de stockage (1) comprenant le matériau à changement de phase selon l'une quelconque des revendications 1 à 7.

10. Puce de stockage selon la revendication 9, chaque unité de stockage comprenant en outre un matériau de déclenchement, et le matériau de déclenchement étant dopé avec du hafnium ou un composé de hafnium.

11. Mémoire à changement de phase (100), comprenant un dispositif de commande (110) et au moins une puce de stockage selon la revendication 9 ou 10, le dispositif de commande étant configuré pour stocker des données sur l'au moins une puce de stockage, ou lire des données à partir de l'au moins une puce de stockage.

12. Dispositif électronique, le dispositif électronique comprenant un processeur et la mémoire à changement de phase selon la revendication 11 et le processeur étant configuré pour stocker des données dans la mémoire à changement de phase, ou lire des données à partir de la mémoire à changement de phase.
